# EUROPÄISCHE PATENTANMELDUNG

(11) **EP 4 700 826 A1**
(43) Veröffentlichungstag der Anmeldung: **25.02.2026**
(21) Anmeldenummer: 24196058.2
(22) Anmeldetag: 23.08.2024
(51) Int. Cl.: H01L 23/00, H01L 23/495

(54) **SUBSTRATANORDNUNG, VERFAHREN ZUR HERSTELLUNG EINER ELEKTRONISCHEN BAUGRUPPE UND ELEKTRONISCHE BAUGRUPPE**

(71) Anmelder: Heraeus Electronics GmbH & Co. KG, 63450 Hanau (DE)
(72) Erfinder: Scharf, Jürgen, 63450 Hanau (DE); Krüger, Frank, 63450 Hanau (DE); Raja Manikam, Vemal, 63450 Hanau (DE)
(74) Vertreter: Heraeus IP

(57) **Zusammenfassung**

Die Erfindung betrifft eine Substratanordnung, ein Verfahren zur Herstellung einer elektronischen Baugruppe und eine elektronische Baugruppe.

Die Substratanordnung weist auf (a) eine Metallfolie, die eine Oberseite und eine Unterseite umfasst, (b) eine Silberschicht, die auf der Unterseite der Metallfolie angeordnet ist, und (c) eine Silbersinterschicht, die auf der Silberschicht angeordnet ist, wobei die Silberschicht eine Dicke d(Ag) im Bereich von 20 - 1500 nm aufweist.

## Beschreibung

Die vorliegende Erfindung betrifft eine Substratanordnung, ein Verfahren zur Herstellung einer elektronischen Baugruppe und eine elektronische Baugruppe.

Zur Herstellung von elektronischen Baugruppen werden in der Leistungselektronik häufig Grundsubstrate, insbesondere Metall-Keramik-Substrate oder Leadframes, mit Elektronikbauteilen, insbesondere Halbleiterbauelementen, bestückt.

Auf der Oberseite der Elektronikbauteile, die den Grundsubstraten abgewandt ist, befinden sich Bereiche, die mit unbestückten Bereichen der Grundsubstrate elektrisch leitend kontaktiert werden müssen. Diese Kontaktierung erfolgt üblicherweise mit Bonddrähten, wobei ein Ende des Bonddrahts stoffschlüssig mit einem Bereich auf der Oberseite des Elektronikbauteils verbunden wird, während das andere Ende des Bonddrahts stoffschlüssig mit einem unbestückten Bereich des Grundsubstrats verbunden wird. Bonddrähte aus Aluminium können mit dem Metall der Grundsubstrate, insbesondere Kupfer, stoffschlüssig verbunden werden. Auch mit den Elektronikbauteilen lassen sich Bonddrähte aus Aluminium, zum Beispiel über eine metallische, zumeist silberhaltige Schicht, die sich auf der Oberseite der Elektronikbauteile befindet, stoffschlüssig verbinden. Bonddrähte aus Aluminium weisen allerdings den Nachteil einer geringen elektrischen Leitfähigkeit auf. Ferner hat sich herausgestellt, dass eine elektrische Kontaktierung von Elektronikbauteilen und Grundsubstraten über Bonddrähte aus Aluminium eine nur unzureichende Zuverlässigkeit und verminderte Funktionsfähigkeit aufweisen.

Aus diesem Grund gibt es den Bedarf, Bonddrähte aus Aluminium durch Bonddrähte aus Kupfer zu ersetzen. Kupfer weist im Vergleich zu Aluminium eine sehr hohe elektrische Leitfähigkeit auf. Darüber hinaus lassen sich Bonddrähte aus Kupfer mit dem Metall der Grundsubstrate, insbesondere Kupfer, besonders zuverlässig stoffschlüssig verbinden. Allerdings können Bonddrähte aus Kupfer nicht ohne weiteres stoffschlüssig mit der Oberseite der Elektronikbauteile verbunden werden.

Im Stand der Technik wird daher vorgeschlagen, Bonddrähte aus Kupfer nicht direkt mit der Oberseite der Elektronikbauteile zu verbinden. Vielmehr wird eine Substratanordnung bereitgestellt, die eine Metallfolie und eine Silbersinterschicht aufweist. Die Metallfolie, weist eine Oberseite und eine Unterseite auf, wobei die Unterseite der Metallfolie mit der Silbersinterschicht, üblicherweise einer vorgetrockneten Sinterpaste, flächig verbunden ist. Die Metallfolie der Substratanordnung wird schließlich über die Silbersinterschicht mit der Oberseite des Elektronikbauteils stoffschlüssig verbunden, so dass die Oberseite der Metallfolie für eine stoffschlüssige Verbindung mit dem Kupferbonddraht zur Verfügung steht. Um eine sichere Verbindung des Bonddrahtes mit der Oberseite des Elektronikbauteils über eine Substratanordnung zu gewährleisten, ist es erforderlich, dass die über die Silbersinterschicht geschaffene stoffschlüssige Verbindung zwischen der Unterseite der Metallfolie und der Oberseite des Elektronikbauteils eine hohe Haftfestigkeit aufweist.

Vor der Ausbildung der stoffschlüssigen Verbindung sollte die Silbersinterschicht ferner hinreichend fest mit der Metallfolie der Substratanordnung verbunden sein. Allerdings hat sich herausgestellt, dass in Substratanordnungen die Silbersinterschicht, üblicherweise eine vorgetrocknete Sinterpaste, nur eine unzureichende Verbindung mit der Metallfolie eingeht. Um die Verbindung zu verbessern, wurde vorgeschlagen, die Metallfolie mit einer Goldschicht zu versehen, die eine verbesserte Anhaftung der Silbersinterschicht ermöglicht. Jedoch ist die Anbindung einer Goldschicht an die Metallfolie nicht ohne weiteres möglich, so dass ein mehrlagiger Schichtenaufbau vorgeschlagen wurde, der zum Beispiel die Metallfolie, eine damit in Kontakt stehende Nickelschicht, eine mit der Nickelschicht in Kontakt stehende Palladiumschicht und eine mit der Palladiumschicht in Kontakt stehende Goldschicht umfasst. Dieser Schichtenaufbau ist sehr aufwendig in der Herstellung.

Es besteht weiterhin Bedarf an einer Substratanordnung, bei der die Metallfolie eine feste Verbindung mit der Silbersinterschicht aufweist und die in der Lage ist, eine stoffschlüssige Verbindung mit hoher Haftfestigkeit zwischen der Unterseite der Metallfolie und der Oberseite eines Elektronikbauteils zu schaffen.

Daher besteht eine Aufgabe der vorliegenden Erfindung vorzugsweise darin, eine Substratanordnung bereitzustellen, bei der die Metallfolie eine feste Verbindung mit der Silbersinterschicht aufweist und die in der Lage ist, eine stoffschlüssige Verbindung mit hoher Haftfestigkeit zwischen der Unterseite der Metallfolie und der Oberseite eines Elektronikbauteils zu schaffen.

Diese Aufgabe wird gelöst durch die Substratanordnung gemäß Anspruch 1.

Die Erfindung stellt daher eine Substratanordnung bereit, aufweisend
(a) eine Metallfolie, die eine Oberseite und eine Unterseite umfasst,
(b) eine Silberschicht, die auf der Unterseite der Metallfolie angeordnet ist, und
(c) eine Silbersinterschicht, die auf der Silberschicht angeordnet ist,
wobei die Silberschicht eine Dicke d(Ag) im Bereich von 20 - 1500 nm aufweist.

Ferner stellt die Erfindung ein Verfahren zur Herstellung einer elektronischen Baugruppe und eine elektronische Baugruppe bereit.

Die Erfindung betrifft eine Substratanordnung.

Mit der Substratanordnung kann vorzugsweise die elektrische Kontaktierung der Oberseite eines Elektronikbauteils mit unbestückten Bereichen von Grundsubstraten vorbereitet werden. Hierzu wird die Metallfolie über die Silbersinterschicht mit der Oberseite des Elektronikbauteils stoffschlüssig verbunden. Die Metallfolie stellt dabei eine Oberfläche bereit, die für die Ausbildung einer zuverlässigen stoffschlüssigen Verbindung mit einem Ende eines Bonddrahtes, insbesondere eines Kupferbonddrahtes, geeignet ist. Das andere Ende des Bonddrahtes kann mit einem unbestückten Bereich eines Grundsubstrats verbunden werden, so dass eine elektrische Kontaktierung zwischen der Oberseite des Elektronikbauteils und einem unbestückten Bereich eines Grundsubstrats über die Metallfolie und den Bonddraht resultiert.

Die Substratanordnung weist eine Metallfolie auf.

Die Metallfolie umfasst eine Oberseite und eine Unterseite. Auf der Unterseite der Metallfolie ist eine Silberschicht angeordnet. Dabei ist die Unterseite der Metallfolie mit der Silberschicht vorzugsweise wenigstens bereichsweise flächig verbunden. Die Unterseite der Metallfolie ist daher vorzugsweise die Fläche der Metallfolie mit dem größten Flächeninhalt, die mit der Silberschicht wenigstens bereichsweise flächig verbunden ist. Daher ist die Oberseite der Metallfolie vorzugsweise die der Silbersinterschicht abgewandte Seite der Metallfolie. Die Oberseite der Metallfolie ist folglich die der Unterseite der Metallfolie gegenüberliegende Seite.

Gemäß einer bevorzugten Ausführungsform ist die Oberseite der Metallfolie nicht stoffschlüssig mit einem Festkörper verbunden. Ein Festkörper ist vorzugsweise ein Körper, der bei einer Temperatur von 25°C und Normaldruck fest ist. Vorzugsweise ist die Oberseite der Metallfolie nicht stoffschlüssig mit einer Schicht aus isolierendem Material verbunden. Besonders bevorzugt ist die Oberseite der Metallfolie nicht stoffschlüssig mit einer Keramikschicht verbunden.

Gemäß einer weiteren bevorzugten Ausführungsform sind weniger als 20 Prozent, mehr bevorzugt weniger als 10 Prozent, noch mehr bevorzugt weniger als 5 Prozent, ganz besonders bevorzugt weniger als 1 Prozent und insbesondere weniger als 0,1 Prozent der Oberseite der Metallfolie, bezogen auf die Gesamtfläche der Oberseite der Metallfolie, mit einem Festkörper unlösbar verbunden. Unlösbar verbunden bedeutet vorzugsweise, dass eine Lösung der Verbindung nicht möglich ist oder eine wenigstens teilweise Zerstörung der Oberseite der Metallfolie, zumindest aber eine Funktionsbeeinträchtigung, zur Folge hätte. Bei dem Festkörper kann es sich um einen Festkörper umfassend isolierendes Material, insbesondere um einen Keramikkörper, handeln.

Gemäß einer weiteren bevorzugten Ausführungsform ist die Oberseite der Metallfolie mit einem Bonddraht, vorzugsweise einem Bonddraht, der wenigstens 50 Gewichtsprozent Kupfer umfasst, verbindbar.

Die Metallfolie weist vorzugsweise eine Dicke d(Me) auf. Die Dicke d(Me) der Metallfolie liegt vorzugsweise im Bereich von 5 - 500 µm, besonders bevorzugt im Bereich von 10 - 200 µm und ganz besonders bevorzugt im Bereich von 20 - 150 µm.

Die Metallfolie umfasst vorzugsweise wenigstens ein Element, das aus der Gruppe ausgewählt ist, die aus Metallen und Metalllegierungen besteht. Die Metallfolie weist vorzugsweise wenigstens 99,5 Gewichtsprozent Metall, besonders bevorzugt wenigstens 99,95 Gewichtsprozent Metall und ganz besonders bevorzugt wenigstens 99,995 Gewichtsprozent Metall, bezogen auf das Gesamtgewicht der Metallfolie, auf. Gemäß einer weiteren bevorzugten Ausführungsform umfasst die Metallfolie wenigstens ein Element, das aus der Gruppe ausgewählt ist, die aus Kupfer und Kupferlegierungen besteht. Dabei kann es bevorzugt sein, dass Kupferlegierungen Legierungen von Kupfer mit wenigstens einem weiteren Metall sind, das aus der Gruppe ausgewählt ist, die aus Nickel, Zinn, Eisen, Silber, Wolfram und Molybdän besteht. Gemäß einer besonders bevorzugten Ausführungsform umfasst die Metallfolie Kupfer. Gemäß einer besonders bevorzugten Ausführungsform ist die Metallfolie eine Kupferfolie. Die Kupferfolie weist vorzugsweise wenigstens 99,5 Gewichtsprozent Kupfer, besonders bevorzugt wenigstens 99,95 Gewichtsprozent Kupfer und ganz besonders bevorzugt wenigstens 99,995 Gewichtsprozent Kupfer, bezogen auf das Gesamtgewicht der Kupferfolie, auf.

Die Substratanordnung weist eine Silberschicht auf.

Die Silberschicht umfasst Silber. Die Silberschicht ist vorzugsweise eine Schicht, die aus Silber oder einer silberhaltigen Legierung, besonders bevorzugt aus Silber, besteht. Der Gehalt an Silber beträgt vorzugsweise wenigstens 70 Gewichtsprozent, mehr bevorzugt wenigstens 95 Gewichtsprozent, besonders bevorzugt wenigstens 99 Gewichtsprozent, ganz besonders bevorzugt wenigstens 99,9 Gewichtsprozent uns insbesondere wenigstens 99,99 Gewichtsprozent, bezogen auf das Gesamtgewicht der Silberschicht.

Die Silberschicht ist auf der Unterseite der Metallfolie angeordnet.

Dabei ist die Silberschicht mit der Unterseite der Metallfolie vorzugsweise wenigstens bereichsweise flächig verbunden. Vorzugsweise ist die Silberschicht mit der Unterseite der Metallfolie flächig so verbunden, dass wenigstens 75%, mehr bevorzugt wenigstens 90%, besonders bevorzugt wenigstens 95%, ganz besonders bevorzugt wenigstens 98% und insbesondere 100%, der von der Unterseite der Metallfolie eingenommenen Fläche mit Silberschicht versehen sind.

Gemäß einer bevorzugten Ausführungsform wird die Silberschicht auf der Unterseite der Metallfolie durch Abscheidung geschaffen.

Die Silberschicht auf der Unterseite der Metallfolie ist vorzugsweise durch chemische (zum Beispiel elektrochemische) oder physikalische Abscheidung geschaffen. Die chemische Abscheidung der Silberschicht kann zum Beispiel galvanisch oder außenstromlos erfolgen. Vorzugsweise erfolgt die chemische Abscheidung der Silberschicht außenstromlos, insbesondere durch Aufbringen einer silberhaltigen Lösung infolge eines Ladungsaustausches zwischen den Metallen, wobei Metall der Metallfolie teilweise in Lösung geht, während sich das in Lösung befindliche Silber abscheidet. Gemäß einer bevorzugten Ausführungsform enthält die silberhaltige Lösung ein Silbersalz und besonders bevorzugt Silbernitrat. Gemäß einer besonders bevorzugten Ausführungsform handelt es sich bei der silberhaltigen Lösung um eine saure Lösung von Silbernitrat und besonders bevorzugt um eine salpetersaure Lösung von Silbernitrat. Die Konzentration von Silber in der salpetersauren Lösung kann zum Beispiel im Bereich von 0,5 - 1,5 g/l, besonders bevorzugt im Bereich von 0,6 - 1,4 g/l und ganz besonders bevorzugt im Bereich von 0,8 - 1,2 g/l liegen. Die physikalische Abscheidung der Silberschicht kann zum Beispiel durch Gasphasenabscheidung erfolgen. Bevorzugte Verfahren zur Gasphasenabscheidung sind dabei insbesondere die Elektronenstrahlabscheidung, die Laserstrahlabscheidung, die Bogenentladungsabscheidung oder das Kathodenzerstäuben. Gemäß einer besonders bevorzugten Ausführungsform ist die Silberschicht auf der Unterseite der Metallfolie durch außenstromlose Abscheidung geschaffen.

Die Silberschicht weist eine Dicke d(Ag) auf. Die Dicke d(Ag) der Silberschicht liegt im Bereich von 20 - 1500 nm. Die Dicke d(Ag) der Silberschicht liegt vorzugsweise im Bereich von 50 - 1200 nm, besonders bevorzugt im Bereich von 100 - 1000 nm und ganz besonders bevorzugt im Bereich von 200 - 800 nm. Die Dicke d(Ag) der Silberschicht kann auf fachübliche Weise, zum Beispiel durch Röntgenfluoreszenzspektrometrie oder durch Röntgenelektronenmikroskopie eines repräsentativen Querschnitts senkrecht zur Oberseite der Metallfolie bestimmt werden.

Überraschenderweise wurde festgestellt, dass die erfindungsgemäße Ausgestaltung der Substratanordnung eine fest ausgeprägte Verbindung zwischen der Metallfolie und der Silbersinterschicht bewirkt und darüber hinaus die Ausbildung einer stoffschlüssigen Verbindung mit hoher Haftfestigkeit zwischen der Metallfolie und der Oberseite eines Elektronikbauteils ermöglicht. Ohne an eine Theorie gebunden zu sein, könnte dies an der besonderen Ausgestaltung der zwischen der Metallfolie und der Silbersinterschicht angebrachten Silberschicht liegen, die erfindungsgemäß eine Dicke d(Ag) im Bereich von 20 - 1500 nm aufweist. Eine solche Silberschicht scheint einerseits eine ausreichende und zuverlässige Bedeckung der Unterseite der Metallfolie zu gewährleisten, so dass die Silbersinterschicht von der Unterseite der Metallfolie durch die Silberschicht getrennt ist. Dabei könnte die Silberschicht eine Funktion als zuverlässiger Haftvermittler zwischen der Silbersinterschicht und der Unterseite der Metallfolie ausüben. Andererseits scheint die Silberschicht ausreichend dünn zu sein, so dass diese nicht als Diffusionssperre wirkt, sondern bei Ausbildung einer stoffschlüssigen Verbindung zwischen der Oberseite eines

Elektronikbauteils und der Substratanordnung eine Diffusion des Metalls der Metallfolie durch die Silberschicht hindurch in Richtung der Oberseite des Elektronikbauteils fördert und somit maßgeblich zur hohen Haftfestigkeit beiträgt.

Gemäß einer bevorzugten Ausführungsform beträgt das Verhältnis R = d(Ag) / d(Me), mithin also das Verhältnis zwischen der Dicke der Silberschicht d(Ag) und der Dicke der Metallfolie d(Me), weniger als 0,05, mehr bevorzugt weniger als 0,02, besonders bevorzugt weniger als 0,01 und ganz besonders bevorzugt weniger als 0,005.

Vorzugsweise beträgt das Verhältnis R = d(Ag) / d(Me) wenigstens 0,0001, besonders bevorzugt wenigstens 0,0005 und ganz besonders bevorzugt wenigstens 0,001.

Vorzugsweise liegt das Verhältnis R = d(Ag) / d(Me) im Bereich von 0,0001 - 0,02, besonders bevorzugt im Bereich von 0,0005 - 0,01 und ganz besonders bevorzugt im Bereich von 0,001 - 0,005.

Gemäß einer weiteren bevorzugten Ausführungsform weist die Anordnung umfassend die Metallfolie und die auf der Unterseite der Metallfolie angeordnete Silberschicht wenigstens eine Durchgangsöffnung auf. Unter Durchgangsöffnung ist vorzugsweise eine Ausnehmung im Material der Metallfolie und der Silberschicht zu verstehen, die sich von einer ersten Öffnung auf der Oberseite der Metallfolie bis zu einer zweiten Öffnung auf der Silberschicht erstreckt. Die Öffnungen können dabei unterschiedliche Größen und Geometrien aufweisen. Es kann bevorzugt sein, dass die Anordnung mehrere Durchgangsöffnungen aufweist. Die Durchgangsöffnungen können beispielsweise zylindrisch, rund, rechteckig, oval, elliptisch oder rechteckig mit abgerundeten Ecken ausgestaltet sein. Die Gegenwart von Durchgangsöffnungen kann insbesondere dann vorteilhaft sein, wenn die Substratanordnung eine Vorfixierschicht umfasst, die ein Vorfixiermittel enthält. In diesem Fall können sich Anteile oder Reste des Vorfixiermittels bei einer Temperaturbeaufschlagung oder Druckbeaufschlagung, wie zum Beispiel bei einem Sintervorgang, verflüssigen und in die Durchgangsöffnungen aufgrund der durch die Durchgangsöffnung hervorgerufenen Kapillarwirkung aufgenommen werden, um dadurch ein unkontrollierbares Austreten der Anteile oder Reste des Vorfixiermittels zu vermeiden.

Die Substratanordnung weist eine Silbersinterschicht auf.

Die Silbersinterschicht ist vorzugsweise eine Schicht, die in der Lage ist, mit einem Elektronikbauteil, insbesondere der gegebenenfalls metallisierten Oberseite eines Elektronikbauteils, eine stoffschlüssige Verbindung einzugehen.

Die Silbersinterschicht umfasst Silber.

Vorzugsweise umfasst die Silbersinterschicht Silber und organische Verbindungen. Der Anteil an Silber in der Silbersinterschicht beträgt vorzugsweise wenigstens 50 Prozent, mehr bevorzugt wenigstens 75 Prozent, besonders bevorzugt wenigstens 85 Prozent und ganz besonders bevorzugt wenigstens 90 Prozent, bezogen auf das Gesamtgewicht der Silbersinterschicht. Der Anteil an organischen Verbindungen beträgt vorzugsweise weniger als 50 Prozent, mehr bevorzugt weniger als 25 Prozent, besonders bevorzugt weniger als 15 Prozent und ganz besonders bevorzugt weniger als 10 Prozent, bezogen auf das Gesamtgewicht der Silbersinterschicht.

Die Silbersinterschicht ist auf der Silberschicht angeordnet.

Dabei ist die Silbersinterschicht eine Schicht, die mit der Silberschicht vorzugsweise wenigstens bereichsweise flächig verbunden ist. Gemäß einer bevorzugten Ausführungsform ist die Silbersinterschicht mit der Silberschicht flächig so verbunden, dass wenigstens 75%, mehr bevorzugt wenigstens 90%, besonders bevorzugt wenigstens 95%, ganz besonders bevorzugt wenigstens 98% und insbesondere 100%, der von der Unterseite der Metallfolie abgewandten Oberfläche der Silberschicht mit Silbersinterschicht und gegebenenfalls einer optional vorhandenen Vorfixierschicht versehen sind.

Die Silbersinterschicht weist vorzugsweise eine Dicke im Bereich von 5 - 500 µm, besonders bevorzugt eine Dicke im Bereich von 5 - 100 µm und ganz besonders bevorzugt eine Dicke im Bereich von 10 - 50 µm auf.

Gemäß einer bevorzugten Ausführungsform umfasst die Silbersinterschicht ein Sintermaterial. Das Sintermaterial ist vorzugsweise aus der Gruppe ausgewählt, die aus Sinterpasten, Sinterfolien und Sintervorformen besteht.

Gemäß einer bevorzugten Ausführungsform umfasst das Sintermaterial eine Sinterpaste. Bei der Sinterpaste handelt es sich vorzugsweise um eine fachübliche Sinterpaste. Vorzugsweise umfasst die Sinterpaste Silber und organische Verbindungen. Es kann bevorzugt sein, dass das Silber in der Sinterpaste in Form von Partikeln vorliegt. Die Partikel können eine beliebige Form annehmen und daher beispielsweise als sphärische Partikel, Flakes oder unregelmäßig geformte Partikel vorliegen. Die organischen Verbindungen sind vorzugsweise aus der Gruppe ausgewählt, die aus Dispersionsmitteln, Bindemitteln, Fettsäuren und Mischungen davon besteht. Die Dispersionsmittel können aus fachüblichen Dispersionsmitteln ausgewählt sein. Ein beispielhaftes Dispersionsmittel ist Terpineol. Die Bindemittel können aus fachüblichen Polymeren ausgewählt sein. Beispielhaft genannt seien Zellulosederivate, so zum Beispiel Methylzellulose, Ethylzellulose, Ethylmethylzellulose, Carboxyzellullose und Hydroxypropylzellullose. Die Fettsäuren können aus fachüblichen Fettsäuren ausgewählt sein. Vorzugsweise sind die Fettsäuren aus der Gruppe ausgewählt, die aus Caprylsäure (Octansäure), Caprinsäure (Decansäure), Laurinsäure (Dodecansäure), Myristinsäure (Tetradecansäure), Palmitinsäure (Hexadecansäure), Margarinsäure (Heptadecansäure), Stearinsäure (Octadecansäure), Arachinsäure (Eicosansäure/Icosansäure), Behensäure (Docosansäure) und Lignocerinsäure (Tetracosansäure) besteht. Vorzugsweise ist die Sinterpaste vorgetrocknet. In diesem Fall umfasst die Silbersinterschicht eine vorgetrocknete Sinterpaste. Die Vortrocknung kann dazu dienen, in der Sinterpaste enthaltenen flüchtigen Bestandteile, wie zum Beispiel organische Verbindungen, wenigstens teilweise zu entfernen. Das Vortrocknen kann zum Beispiel bei einer Temperatur im Bereich von 80 - 150°C und beispielsweise für einen Zeitraum von 2 - 30 Minuten erfolgen.

Gemäß einer weiteren bevorzugten Ausführungsform umfasst das Sintermaterial eine Sinterfolie. Vorzugsweise handelt es sich bei der Sinterfolie um eine fachübliche Sinterfolie, wie sie zum Beispiel in der europäischen Patentanmeldung EP3154729 A1 offenbart ist. Eine Sinterfolie kann daher zum Beispiel eine Sinterpaste, die Silberpartikel und organische Verbindungen (wie zum Beispiel ein Bindemittel) umfasst, aufweisen, die auf einem Trägersubstrat vorgetrocknet vorliegt. Die Sinterfolie kann zum Beispiel eine Dicke im Bereich von 5 - 300 µm aufweisen.

Gemäß einer weiteren bevorzugten Ausführungsform umfasst das Sintermaterial eine Sintervorform. Vorzugsweise handelt es sich bei der Sintervorform um eine fachübliche Sintervorform, wie sie zum Beispiel in der europäischen Patentanmeldung EP2428293 A2 offenbart ist.

Gemäß einer besonders bevorzugten Ausführungsform umfasst die Silbersinterschicht eine vorgetrocknete Sinterpaste.

Die Silberschicht und die Silbersinterschicht lassen sich optisch voneinander unterscheiden. Besonders bevorzugt erfolgt eine Unterscheidung von Silberschicht und Silbersinterschicht an einer elektronenmikroskopischen Aufnahme (zum Beispiel einer röntgenelektronenmikroskopischen Aufnahme). Vorzugsweise weist die Silbersinterschicht eine höhere Porosität und damit eine geringere Dichte auf als die Silberschicht.

Gemäß einer bevorzugten Ausführungsform umfasst die Substratanordnung eine Vorfixierschicht.

Die Vorfixierschicht ist vorzugsweise eine Schicht, die mit wenigstens einer weiteren Schicht verbunden ist. Die wenigstens eine weitere Schicht ist vorzugsweise wenigstens eine Schicht, die aus der Gruppe ausgewählt ist, die aus der Silberschicht und der Silbersinterschicht besteht. Bei der Vorfixierschicht kann es sich zum Beispiel um eine zusammenhängende Schicht oder um eine unterbrochene Schicht handeln. Die Dimension der zusammenhängenden Schicht ist nicht weiter eingeschränkt. Daher umfasst die zusammenhängende Schicht auch eine punktförmige Schicht. Im Fall einer zusammenhängenden Schicht kann die Vorfixierschicht mit der wenigstens einen weiteren Schicht flächig verbunden sein. Im Fall einer unterbrochenen Schicht kann die Vorfixierschicht mehrere nicht miteinander in Kontakt stehende Abschnitte umfassen, die mit der wenigstens einen weiteren Schicht flächig verbunden sind. Bei der wenigstens einen weiteren Schicht handelt es sich vorzugsweise um die Silberschicht oder die Silbersinterschicht. Gemäß einer bevorzugten Ausführungsform ist die Vorfixierschicht eine Schicht, die (i) mit der Silberschicht, (ii) mit der Silbersinterschicht oder (iii) mit der Silberschicht und der Silbersinterschicht verbunden ist. Sofern die Vorfixierschicht mit der Silberschicht verbunden ist, ist die Silbersinterschicht mit der Silberschicht vorzugsweise bereichsweise flächig verbunden und die Vorfixierschicht ist mit Bereichen der Silberschicht verbunden, die nicht flächig mit der Silbersinterschicht verbunden sind. Dabei sind die Silbersinterschicht und die Vorfixierschicht jeweils mit der Silberschicht verbunden und vorzugsweise nebeneinander angeordnet.

Gemäß einer bevorzugten Ausführungsform ist die Vorfixierschicht als zusammenhängende Schicht ausgebildet und mit der Silbersinterschicht flächig verbunden, so dass wenigstens 20%, mehr bevorzugt wenigstens 50%, besonders bevorzugt wenigstens 70%, ganz besonders bevorzugt wenigstens 98% und insbesondere 100%, der Silbersinterschicht mit der Vorfixierschicht in Kontakt stehen.

Gemäß einer weiteren bevorzugten Ausführungsform ist die Vorfixierschicht als zusammenhängende Schicht punktförmig ausgebildet und steht mit der Silbersinterschicht und/oder mit der Silberschicht in Kontakt.

Gemäß einer weiteren bevorzugten Ausführungsform ist die Vorfixierschicht als unterbrochene Schicht umfassend mehrere nicht miteinander in Kontakt stehende Abschnitte ausgebildet, die mit der Silbersinterschicht und/oder mit der Silberschicht in Kontakt stehen.

Die Vorfixierschicht umfasst vorzugsweise ein Vorfixiermittel. Das Vorfixiermittel kann zu einer Vorfixierung der Substratanordnung an einem Elektronikbauteil dienen, damit der Aufbau umfassend die Substratanordnung und das Elektronikbauteil eine verbesserte Transportfähigkeit - zum Beispiel zum Ort der Weiterverarbeitung - aufweist. Vorzugsweise ist das Vorfixiermittel ein temporäres oder lösbares Fixiermittel, das zumindest eine vorübergehende Fixierung der Substratanordnung mit einem Elektronikbauteil ermöglicht. Geeignete Vorfixiermittel sind zum Beispiel in der europäischen Patentanmeldung EP3940758 A2 beschrieben.

Das Vorfixiermittel umfasst daher vorzugsweise wenigstens eine Verbindung, die aus der Gruppe ausgewählt ist, die aus thermoplastischen Polymeren, anorganischen Füllstoffpartikeln und organischen Lösungsmitteln besteht. Gemäß einer bevorzugten Ausführungsform umfasst das Vorfixiermittel wenigstens ein thermoplastisches Polymer und besonders bevorzugt wenigstens eine Verbindung, die aus der Gruppe ausgewählt ist, die aus anorganischen Füllstoffpartikeln und organischen Lösungsmitteln besteht.

Die thermoplastischen Polymere weisen vorzugsweise eine Glasübergangstemperatur im Bereich von 60 - 120 °C auf. Die Bestimmung der Glasübergangstemperatur wird vorzugsweise mittels Dynamischer Differenzkalorimetrie (DKK) oder mittels Differential Scanning Calorimetry (DSC) bei einer Aufheizrate von 10 °C/Minute durchgeführt. Bei den thermoplastischen Polymeren kann es sich insbesondere um (Meth)acrylcopolymere handeln. Die (Meth)acrylcopolymere weisen vorzugsweise eine Molmasse im Bereich von 35.000 - 70.000 g/mol auf (Mw = 35.000 bis 70.000 g/mol). Die Molmasse wird vorzugsweise mittels Gelpermeationschromatographie (GPC) bestimmt. Für die Gelpermeationschromatographie gilt: Polystyrolgel als stationäre Phase, Tetrahydrofuran als mobile Phase, Polystyrolstandards.

Die anorganischen Füllstoffpartikel sind vorzugsweise Partikel umfassend wenigstens ein Element, das aus der Gruppe ausgewählt ist, die aus Aluminiumoxid, Siliziumdioxid, Titandioxid, Zirkonsilikat, Calciumsilikat, Glimmer, Kaolin und α-Bornitrid besteht. Vorzugsweise weisen die anorganischen Füllstoffpartikel eine durchschnittliche Teilchengröße (d50) im Bereich von 5 - 20 µm und besonders bevorzugt im Bereich von 5 - 10 µm auf. Die Bestimmung der durchschnittlichen Teilchengröße (d50) erfolgt vorzugsweise mittels eines Laserbeugungsverfahrens.

Die organischen Lösungsmittel weisen vorzugsweise einen Siedepunkt von nicht mehr als 285°C auf. Gemäß einer bevorzugten Ausführungsform sind die organischen Lösungsmittel aus der Gruppe ausgewählt, die aus Aromaten, Ketonen, Estern, Glykolethern und Alkoholen besteht. Gemäß einer besonders bevorzugten Ausführungsform sind die organischen Lösungsmittel aus der Gruppe ausgewählt, die aus Toluol, Xylol, Methylethylketon, Methylisobutylketon, Ethylacetat, Isobutylacetat, Bernsteinsäuredimethylester, Diethylenglykolmonobutylether, Benzylalkohol und Terpineolen besteht. Gemäß einer ganz besonders bevorzugten Ausführungsform sind die organischen Lösungsmittel aus der Gruppe der Terpineole ausgewählt.

Gemäß einer bevorzugten Ausführungsform ist die Substratanordnung zur Verbindung mit wenigstens einem Elektronikbauteil geeignet. Gemäß einer besonders bevorzugten Ausführungsform ist die Substratanordnung zur Verbindung der Metallfolie mit wenigstens einem Elektronikbauteil geeignet.

Unter Elektronikbauteil wird vorzugsweise ein elektronisches oder elektrisches Bauelement verstanden. Das Elektronikbauteil ist vorzugsweise aus der Gruppe ausgewählt, die aus Halbleiterbauelementen besteht. Die Halbleiterbauelementen sind vorzugsweise aus der Gruppe ausgewählt, die aus Transistoren, Dioden und integrierten Schaltkreisen besteht.

Gemäß einer bevorzugten Ausführungsform umfasst das Elektronikbauteil eine metallische Oberseitenbeschichtung. Die metallische Oberseitenbeschichtung kann dazu dienen, eine leichtere Anbindung der Metallfolie über die Silbersinterschicht an die Oberseite des Elektronikbauteils zu ermöglichen. Daher kann es bevorzugt sein, dass die Oberseite des Elektronikbauteils von der metallischen Oberseitenbeschichtung geschaffen wird. Vorzugsweise umfasst die metallische Oberseitenbeschichtung des Elektronikbauteils wenigstens ein Element, das aus der Gruppe ausgewählt ist, die aus Nickel, Palladium, Silber und Gold besteht. Gemäß einer bevorzugten Ausführungsform umfasst das Elektronikbauteil eine metallische Unterseitenbeschichtung. Die metallische Unterseitenbeschichtung kann dazu dienen, eine leichtere Anbindung des Grundsubstrats an die Unterseite des Elektronikbauteils zu ermöglichen. Daher kann es bevorzugt sein, dass die Unterseite des Elektronikbauteils von der metallischen Unterseitenbeschichtung geschaffen wird. Vorzugsweise umfasst die metallische Unterseitenbeschichtung des Elektronikbauteils wenigstens ein Edelmetall. Gemäß einer bevorzugten Ausführungsform umfasst die metallische Unterseitenbeschichtung des Elektronikbauteils wenigstens ein Element, das aus der Gruppe ausgewählt ist, die aus Gold, Silber, Aluminium, Titan und Nickel besteht, und ganz besonders bevorzugt Silber.

Mit der Substratanordnung kann vorzugsweise die elektrische Kontaktierung der Oberseite des Elektronikbauteils mit unbestückten Bereichen von Grundsubstraten vorbereitet werden. Hierzu wird die Metallfolie über die Silbersinterschicht mit der Oberseite des Elektronikbauteils stoffschlüssig verbunden. Die Metallfolie stellt dabei eine Oberfläche bereit, die für die stoffschlüssige Verbindung mit einem Bonddraht, insbesondere einem Kupferbonddraht, auf besonders stabile Weise geeignet ist.

Das Verfahren zur Herstellung der erfindungsgemäßen Substratanordnung ist nicht weiter eingeschränkt.

Gemäß einer bevorzugten Ausführungsform umfasst das Verfahren zur Herstellung der erfindungsgemäßen Substratanordnung die Schritte:
(A) Bereitstellung einer Metallfolie, die eine Oberseite und eine Unterseite umfasst,
(B) Schaffen einer Silberschicht, die auf der Unterseite der Metallfolie angeordnet ist, wobei die Silberschicht eine Dicke d(Ag) im Bereich von 20 - 1500 nm aufweist, und
(C) Schaffen einer Silbersinterschicht, die auf der Silberschicht angeordnet ist.

In Schritt (A) des Verfahrens wird eine Metallfolie bereitgestellt.

Bei der Metallfolie handelt es sich vorzugsweise um eine wie hierin an anderer Stelle beschriebene Metallfolie.

In Schritt (B) wird eine Silberschicht geschaffen, die auf der Unterseite der Metallfolie angeordnet ist, wobei die Silberschicht eine Dicke d(Ag) im Bereich von 20 - 1500 nm aufweist.

Die auf der Unterseite der Metallfolie angeordnete Silberschicht wird vorzugsweise durch Abscheidung geschaffen. Die Abscheidung erfolgt vorzugsweise chemisch (zum Beispiel elektrochemische) oder physikalisch. Die chemische Abscheidung der Silberschicht kann zum Beispiel galvanisch oder außenstromlos erfolgen. Vorzugsweise erfolgt die chemische Abscheidung der Silberschicht außenstromlos, insbesondere durch Aufbringen einer silberhaltigen Lösung infolge eines Ladungsaustausches zwischen den Metallen, wobei Metall der Metallfolie teilweise in Lösung geht, während sich das in Lösung befindliche Silber abscheidet. Gemäß einer bevorzugten Ausführungsform enthält die silberhaltige Lösung ein Silbersalz und besonders bevorzugt Silbernitrat. Gemäß einer besonders bevorzugten Ausführungsform handelt es sich bei der silberhaltigen Lösung um eine saure Lösung von Silbernitrat und besonders bevorzugt um eine salpetersaure Lösung von Silbernitrat. Die Konzentration von Silber in der salpetersauren Lösung kann zum Beispiel im Bereich von 0,5 - 1,5 g/l, besonders bevorzugt im Bereich von 0,6 - 1,4 g/l und ganz besonders bevorzugt im Bereich von 0,8 - 1,2 g/l liegen. Die physikalische Abscheidung der Silberschicht kann zum Beispiel durch Gasphasenabscheidung erfolgen. Bevorzugte Verfahren zur Gasphasenabscheidung sind dabei insbesondere die Elektronenstrahlabscheidung, die Laserstrahlabscheidung, die Bogenentladungsabscheidung oder das Kathodenzerstäuben. Gemäß einer besonders bevorzugten Ausführungsform wird die Silberschicht auf der Unterseite der Metallfolie durch außenstromlose Abscheidung geschaffen.

In Schritt (C) wird eine Silbersinterschicht geschaffen, die auf der Silberschicht angeordnet ist.

Hierzu wird vorzugsweise ein Sintermaterial bereitgestellt. Das Silbermaterial ist vorzugsweise aus der Gruppe ausgewählt, die aus Sinterpasten, Sinterfolien und Sintervorformen besteht. Bei dem Sintermaterial handelt es vorzugsweise um ein wie hierin an anderer Stelle beschriebenes Sintermaterial.

Das Sintermaterial wird vorzugsweise auf die Silberschicht aufgebracht. Das Aufbringen des Sintermaterials auf die Silberschicht unter Ausbildung einer Silbersinterschicht kann durch fachübliche Verfahren erfolgen, insbesondere auch in Abhängigkeit davon, in welcher Ausgestaltungsform das Sintermaterial (zum Beispiel als Sinterpaste, Sinterfolie und/oder Sintervorform) bereitgestellt wird. Vorzugsweise erfolgt das Aufbringen des Sintermaterials durch Jetten, Dispensen, Sprühen, Pinseln, Tupfen, Tauchen, Auflegen, Pressen oder Drucken, insbesondere Siebdrucken oder Schablonendrucken.

Gemäß einer bevorzugten Ausführungsform erfolgt in einem weiteren Schritt (D) das Aufbringen eines Vorfixiermittels auf die Silbersinterschicht und/oder die Silberschicht unter Ausbildung einer Vorfixierschicht. Bei dem Vorfixiermittel handelt es sich vorzugsweise um ein wie hierin an anderer Stelle beschriebenes Vorfixiermittel. Das Aufbringen des Vorfixiermittels auf die Silbersinterschicht und/oder die Silberschicht kann durch fachübliche Verfahren erfolgen. Vorzugsweise erfolgt das Aufbringen des Vorfixiermittels durch Jetten, Dispensen, Sprühen, Pinseln, Tupfen, Tauchen oder Drucken, insbesondere Siebdrucken oder Schablonendrucken.

Gemäß einer bevorzugten Ausführungsform erfolgt in einem weiteren Schritt (E) des Verfahrens eine Vortrocknung. Die Vortrocknung kann dazu dienen, in dem Sintermaterial und falls vorhanden in dem Vorfixiermittel enthaltene flüchtige Bestandteile, wie zum Beispiel organische Verbindungen, wenigstens teilweise zu entfernen. Das Vortrocknen kann zum Beispiel bei einer Temperatur im Bereich von 80 - 150°C und beispielsweise für einen Zeitraum von 2 - 30 Minuten erfolgen. Die Vortrocknung hat üblicherweise einen Volumenschwund zur Folge, so dass auch die Dicke der zunächst erzeugten Silbersinterschicht und falls vorhanden der zunächst erzeugten Vorfixierschicht reduziert wird.

Gemäß einer weiteren Ausführungsform ist es möglich, dass das Aufbringen eines Vorfixiermittels auf die Silbersinterschicht und/oder die Silberschicht unter Ausbildung einer Vorfixierschicht (gemäß Schritt D) nach der Vortrocknung (gemäß Schritt E) erfolgt.

Bei dem Verfahren wird eine Substratanordnung erhalten, mit der die Metallfolie mit der Oberseite eines Elektronikbauteils über die Silbersinterschicht besonders stabil stoffschlüssig verbunden werden kann.

Die Erfindung stellt ein Verfahren zur Herstellung einer elektronischen Baugruppe bereit.

Das Verfahren umfasst die folgenden Schritte:
(A) Bereitstellung eines Grundsubstrats, das eine Oberseite aufweist, wobei das Grundsubstrat eine Metallschicht umfasst,
(B) Bereitstellung eines Elektronikbauteils, das eine Oberseite und eine Unterseite aufweist,
(C) Bereitstellung einer hierin beschriebenen Substratanordnung,
(D) Kontaktierung der Oberseite des Grundsubstrats mit der Unterseite des Elektronikbauteils unter Ausbildung einer stoffschlüssigen Verbindung und
(E) Kontaktierung der Oberseite des Elektronikbauteils mit der Silbersinterschicht der Substratanordnung unter Ausbildung einer stoffschlüssigen Verbindung.

In Schritt (A) des Verfahrens wird ein Grundsubstrat bereitgestellt. Das Grundsubstrat umfasst eine Metallschicht. Ferner weist das Grundsubstrat eine Oberseite auf.

Die Metallschicht des Grundsubstrats kann zum Beispiel Kupfer umfassen. Vorzugsweise kann die Metallschicht des Grundsubstrats aus einer Metallfolie gebildet sein. Gemäß einer bevorzugten Ausführung umfasst die Metallschicht des Grundsubstrats eine Kupferfolie.

Gemäß einer bevorzugten Ausführungsform besteht das Grundsubstrat aus der Metallschicht.

Gemäß einer anderen bevorzugten Ausführungsform umfasst das Grundsubstrat eine Metallschicht und eine Schicht aus isolierendem Material. Gemäß einer weiteren bevorzugten Ausführungsform umfasst das Grundsubstrat eine Metallschicht und eine Schicht aus isolierendem Material, die stoffschlüssig miteinander verbunden sind. Vorzugsweise umfasst das Grundsubstrat eine Schicht aus isolierendem Material, die auf einer ersten Seite und einer der ersten Seite abgewandten zweiten Seite stoffschlüssig mit einer Metallschicht verbunden ist.

Das isolierende Material des Grundsubstrats ist vorzugsweise aus der Gruppe ausgewählt, die aus Glas und Keramik besteht. Die Keramik kann zum Beispiel aus der Gruppe ausgewählt sein, die aus Oxidkeramiken, Nitridkeramiken und Carbidkeramiken besteht.

Gemäß einer bevorzugten Ausführungsform ist das Grundsubstrat aus der Gruppe ausgewählt, die aus Metall-Keramik-Substraten, Printed Circuit Boards (PCBs) und Leadframes besteht. Gemäß einer besonders bevorzugten Ausführungsform handelt es sich bei dem Grundsubstrat um ein fachübliches Metall-Keramik-Substrat. Das Metall-Keramik-Substrat ist vorzugsweise aus der Gruppe ausgewählt, die aus DCB (Direct Copper Bonded)-Substraten und AMB (Active Metal Brazed)-Substraten besteht.

Die Oberseite des Grundsubstrats wird vorzugsweise durch die Metallschicht geschaffen.

In Schritt (B) des Verfahrens wird ein Elektronikbauteil bereitgestellt. Das Elektronikbauteil weist eine Oberseite und eine Unterseite auf.

Bei dem Elektronikbauteil handelt es vorzugsweise um ein wie hierin an anderer Stelle beschriebenes Elektronikbauteil.

In Schritt (C) des Verfahrens wird eine Substratanordnung bereitgestellt.

Bei der Substratanordnung handelt es sich vorzugsweise um eine wie hierin an anderer Stelle beschriebene Substratanordnung.

Die Substratanordnung weist daher vorzugsweise auf
(a) eine Metallfolie, die eine Oberseite und eine Unterseite umfasst,
(b) eine Silberschicht, die auf der Unterseite der Metallfolie angeordnet ist, wobei die Silberschicht eine Dicke d(Ag) im Bereich von 20 - 1500 nm aufweist, und
(c) eine Silbersinterschicht, die auf der Silberschicht angeordnet ist.

In Schritt (D) des Verfahrens wird die Oberseite des Grundsubstrats mit der Unterseite des Elektronikbauteils unter Ausbildung einer stoffschlüssigen Verbindung kontaktiert.

Das Grundsubstrat und das Elektronikbauteil werden hierzu vorzugsweise so positioniert, dass die Unterseite des Elektronikbauteils mit der Oberseite des Grundsubstrats vorzugsweise über ein Kontaktierungsmaterial in Kontakt steht. Bei dem Kontaktierungsmittel kann es sich beispielsweise um eine Sinterpaste, eine Lotpaste oder einen Leitkleber handeln. Der Aufbau umfassend das Grundsubstrat und das Elektronikbauteil wird anschließend einer Behandlung unterzogen, die eine stoffschlüssige Verbindung durch das Kontaktierungsmaterial erlaubt. Dabei wird die Unterseite des Elektronikbauteils auf der Oberseite des Grundsubstrats befestigt. Die Behandlung erfolgt vorzugsweise durch Einbringung von Energie. Die Einbringung von Energie kann vorzugsweise in Form von Temperaturbeaufschlagung und besonders bevorzugt in Form von Temperatur- und Druckbeaufschlagung erfolgen.

In Schritt (E) des Verfahrens wird die Oberseite des Elektronikbauteils mit der Silbersinterschicht der Substratanordnung unter Ausbildung einer stoffschlüssigen Verbindung kontaktiert. Dabei erfolgt vorzugsweise die Ausbildung einer stoffschlüssigen Verbindung zwischen der Oberseite des Elektronikbauteils und der Metallfolie der Substratanordnung.

Die Substratanordnung und das Elektronikbauteil werden hierzu vorzugsweise so positioniert, dass die Silbersinterschicht der Substratanordnung mit der Oberseite des Elektronikbauteils in Kontakt steht. Der Aufbau umfassend die Substratanordnung und das Elektronikbauteil wird anschließend einer Behandlung unterzogen, die eine stoffschlüssige Verbindung durch die Silbersinterschicht erlaubt. Dabei wird die Metallfolie der Substratanordnung auf der Oberseite des Elektronikbauteils befestigt. Die Behandlung erfolgt vorzugsweise durch Einbringung von Energie. Die Einbringung von Energie kann vorzugsweise in Form von Temperaturbeaufschlagung und besonders bevorzugt in Form von Temperatur- und Druckbeaufschlagung erfolgen.

Infolge der Temperaturbeaufschlagung bildet sich vorzugsweise eine Diffusionszone zwischen der Metallfolie und der durch die stoffschlüssige Verbindung geschaffene Verbindungszone zwischen der Metallfolie und der Oberseite des Elektronikbauteils aus. Die Diffusionszone erstreckt sich vorzugsweise von der Metallfolie senkrecht zur Metallfolie in Richtung der Oberseite des Elektronikbauteils. Die Diffusionszone weist vorzugsweise eine Breite im Bereich von 0,5 µm - 3,0 µm und besonders bevorzugt eine Breite im Bereich von 0,8 µm - 2,0 µm auf. Die Diffusionszone umfasst vorzugsweise wenigstens anteilig Bereiche der Metallfolie, der Silberschicht und der Verbindungszone. Die Dicke der Diffusionszone kann zum Beispiel durch Rasterelektronenmikroskopie - energiedispersive Röntgenspektroskopie (REM-EDX) gemessen werden. Dazu wird vorzugsweise ein Schliff durch die elektronische Baugruppe senkrecht zur Metallfolie angefertigt. Die Schlifffläche wird vorzugsweise unter einem Rasterelektronenmikroskop in einem Linienscan abgefahren und dabei mittels REM-EDX die Elementverteilung gemessen. Die Elementsignale (in cps, counts per second) können sodann in Abhängigkeit von der Messlänge (in µm) bestimmt werden. Die so erhaltenen Kurven zur Elementverteilung können anschließend ausgewertet werden. Beginnend von einem ersten Abfall des Kupfersignals bis zu einem Wert von ca. 0 cps (Grundrauschen) erstreckt sich vorzugsweise die Diffusionszone. Überraschenderweise konnte festgestellt werden, dass eine Diffusion von Metall der Metallschicht über die Silberschicht hinaus in Richtung der Oberseite des Elektronikbauteils die Haftfestigkeit der stoffschlüssigen Verbindung deutlich erhöht werden kann.

Die Schritte (D) und (E) können in einem Fertigungsschritt oder in unterschiedlichen Fertigungsschritten durchgeführt werden. Dabei können die Schritte (D) und (E) sequenziell oder gleichzeitig durchgeführt werden.

Sofern die Schritte (D) und (E) sequenziell durchgeführt werden, kann Schritt (D) zeitlich vor Schritt (E) erfolgen. Andererseits ist es auch möglich, dass Schritt (E) vor Schritt (D) erfolgt.

Sofern die Schritte (D) und (E) sequenziell durchgeführt werden, kann gemäß einer ersten Ausführungsform in Schritt (D) das Elektronikbauteil Teil einer ersten Anordnung sein, die das Elektronikbauteil und die Metallfolie der Substratanordnung umfasst. In diesem Fall kann zunächst in Schritt (E) eine erste Anordnung, die das Elektronikbauteil und die Metallfolie der Substratanordnung umfasst, hergestellt werden, indem die Oberseite des Elektronikbauteils mit der Metallfolie der Substratanordnung unter Ausbildung einer stoffschlüssigen Verbindung zwischen der Oberseite des Elektronikbauteils und der Metallfolie der Substratanordnung kontaktiert wird. Diese erste Anordnung kann anschließend in Schritt (D) mit dem Grundsubstrat kontaktiert werden, so dass die Unterseite des Elektronikbauteils als Teil der ersten Anordnung mit der Oberseite des Grundsubstrats stoffschlüssig verbunden wird.

Sofern die Schritte (D) und (E) sequenziell durchgeführt werden, kann gemäß einer zweiten Ausführungsform in Schritt (E) das Elektronikbauteil Teil einer zweiten Anordnung sein, die das Grundsubstrat und das Elektronikbauteil umfasst. In diesem Fall kann zunächst in Schritt (D) eine zweite Anordnung, die das Grundsubstrat und das Elektronikbauteil umfasst, hergestellt werden. Diese zweite Anordnung kann anschließend in Schritt (E) mit der Substratanordnung kontaktiert werden, so dass die Metallfolie der Substratanordnung mit der Oberseite des Elektronikbauteils als Teil der zweiten Anordnung stoffschlüssig verbunden wird.

Durch die stoffschlüssige Verbindung von Grundsubstrat, Elektronikbauteil und Metallfolie der Substratanordnung wird eine elektronische Baugruppe erhalten.

Die elektronische Baugruppe ist durch eine ausgeprägte Diffusionszone gekennzeichnet. Die Diffusionszone erstreckt sich vorzugsweise von der Metallfolie senkrecht zur Metallfolie in Richtung der Oberseite des Elektronikbauteils. Die Diffusionszone weist vorzugsweise eine Breite im Bereich von 0,5 µm - 3,0 µm und besonders bevorzugt eine Breite im Bereich von 0,8 µm - 2,0 µm auf. Die Diffusionszone umfasst vorzugsweise wenigstens anteilig Bereiche der Metallfolie, der Silberschicht und der Verbindungszone. Die Dicke der Diffusionszone kann wie vorstehend beschrieben gemessen werden, zum Beispiel durch Rasterelektronenmikroskopie - energiedispersive Röntgenspektroskopie (REM-EDX).

Gemäß einer bevorzugten Ausführungsform erfolgt in einem weiteren Schritt (F) die elektrische Kontaktierung eines Bereichs auf der Oberseite der Metallfolie mit einem Bereich auf der Oberseite des Grundsubstrats. Die elektrische Kontaktierung erfolgt vorzugsweise durch Drahtbonden. Für das Drahtbonden wird vorzugsweise ein Bonddraht verwendet. Der Bonddraht umfasst vorzugsweise Kupfer. Gemäß einer bevorzugten Ausführungsform ist der Bonddraht aus einem Material beschaffen, das aus der Gruppe ausgewählt ist, die aus Kupfer und Kupferlegierungen besteht.

### Figurenbeschreibung:

Weitere Merkmale und Vorteile der Erfindung ergeben sich aus der nachfolgenden Figurenbeschreibung, in der bevorzugte Ausführungsformen der Erfindung anhand von schematischen Zeichnungen erläutert sind.

Dabei zeigen:
Figur 1 die Seitenansicht einer erfindungsgemäßen Substratanordnung und
Figur 2 die Seitenansicht einer elektronischen Baugruppe, die durch das erfindungsgemäße Verfahren erhalten wird.

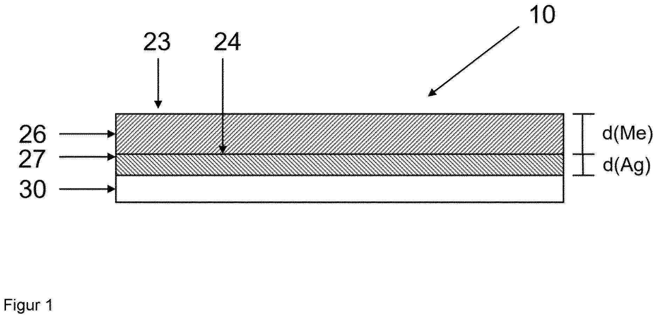

Figur 1 zeigt - nicht maßstabsgetreu - eine erfindungsgemäße Substratanordnung 10, die eine Metallfolie 26, eine Silberschicht 27 und eine Silbersinterschicht 30 umfasst. Die Metallfolie 26 weist eine Oberseite 23 und eine Unterseite 24 auf. Die Metallfolie 26 weist eine Dicke d(Me) auf. Die Silberschicht 27 ist auf der Unterseite 24 der Metallfolie 26 angeordnet. Die Silberschicht 27 weist eine Dicke d(Ag) im Bereich von 20 - 1500 nm auf. Die Silbersinterschicht 30 ist auf der Silberschicht 27 angeordnet.

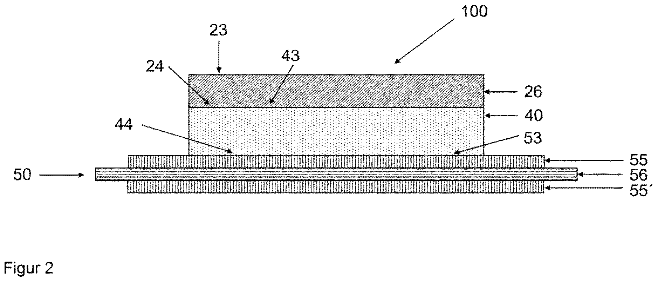

Figur 2 zeigt eine elektronische Baugruppe 100, die durch das erfindungsgemäße Verfahren hergestellt werden kann. Die elektronische Baugruppe 100 umfasst eine Metallfolie 26, ein Elektronikbauteil 40 und ein Grundsubstrat 50. Das Grundsubstrat 50 weist eine Schicht aus isolierendem Material 56 auf, die beidseitig mit einer Metallschicht 55, 55' flächig verbunden ist. Bei dem Grundsubstrat 50 handelt es sich typischerweise um ein Metall-Keramik-Substrat. Die Oberseite 53 des Grundsubstrats 50 wird durch die Metallschicht 55 geschaffen. Auf der Oberseite 53 des Grundsubstrats 50 ist ein Elektronikbauteil 40 angeordnet, das eine Oberseite 43 und eine Unterseite 44 aufweist. Die Unterseite 44 des Elektronikbauteils 40 ist auf der Oberseite 53 des Grundsubstrats 50 angeordnet. Das Elektronikbauteil 40 ist mit dem Grundsubstrat 50 flächig verbunden. Hierzu kann das Elektronikbauteil 40 zum Beispiel unter Verwendung einer Sinterpaste auf dem Grundsubstrat 50 befestigt sein. Zwischen der Oberseite 53 des Grundsubstrats 50 und der Unterseite 44 des Elektronikbauteils 40 kann sich daher eine Verbindungszone befinden (nicht gezeigt). Das Elektronikbauteil 40 ist mit einer Metallfolie 26 über eine Verbindungszone (nicht gezeigt) verbunden. Die Metallfolie 26 weist eine Oberseite 23 und eine Unterseite 24 auf. Die Unterseite 24 der Metallfolie 26 ist auf der Oberseite 43 des Elektronikbauteils 40 angeordnet. Die Metallfolie 26 ist auf dem Elektronikbauteil 40 befestigt. Die Befestigung erfolgt, indem zunächst eine Substratanordnung, die die Metallfolie 26, eine Silberschicht und eine Silbersinterschicht umfasst, auf der Oberseite 43 des Elektronikbauteils 40 so positioniert wird, dass die Silbersinterschicht mit der Oberseite 43 des Elektronikbauteils 40 in Kontakt steht. Anschließend wird der so erhaltene Aufbau Bedingungen ausgesetzt, die die Ausbildung einer stoffschlüssigen Verbindung zwischen der Metallfolie 26 und dem Elektronikbauteil 40 ermöglichen. Die Silbersinterschicht kann beispielsweise aus einer vorgetrockneten Sinterpaste bestehen. In diesem Fall wird der Aufbau zum Beispiel mit Temperatur und Druck beaufschlagt, um die Ausbildung einer Sinterverbindung zwischen der Metallfolie 26 und dem Elektronikbauteil 40 zu ermöglichen. Bei der Ausbildung der Sinterverbindung wird zwischen der Metallfolie 26 und dem Elektronikbauteil 40 durch die Silberschicht und die Silbersinterschicht die Verbindungszone geschaffen (nicht gezeigt). Die Oberseite 23 der Metallfolie 26 kann mit unbestückten Bereichen auf der Oberseite 53 des Grundsubstrats 50 mit einem Bonddraht kontaktiert werden (nicht gezeigt). Die Oberseite 23 der Metallfolie 26 kann außerdem mit einer weiteren Komponente, insbesondere unter Verwendung eines Sintermaterials, stoffschlüssig verbunden werden (nicht gezeigt).

### Beispiele:

Die vorliegende Erfindung wird nachstehend anhand von Beispielen veranschaulicht, die jedoch nicht als einschränkend zu verstehen sind.

### 1. Herstellung von Substratanordnungen

Zur Herstellung einer Substratanordnung gemäß den Beispielen und den Vergleichsbeispielen wurden Kupferfolien mit einer Dicke von 50 µm verwendet. Diese wurden auf einer Transferfolie aus Kunststoff angeordnet und in einen Rahmen gespannt. Die geträgerten Kupferfolien wurden mittels fotolithografischem Ätzen unter Verwendung einer geeigneten Maskierung mit einer Eisenchlorid (FeCl₃)-Ätzlösung in Kupferfolienstücke der Abmaße 7,6 mm x 7,6 mm strukturiert, wobei die einzelnen Kupferfolienstücke noch über Stege miteinander verbunden waren. Die Maskierung wurde anschließend entfernt.

Die so erhaltenen Kupferfolienstücke wurden mit einem handelsüblichen wässrigen Reinigungsmittel gereinigt und mit Wasser gespült. Danach wurde die Oberfläche der Kupferfolienstücke durch Kontaktierung mit einer wässrigen Natriumperoxodisulfat-Lösung (Konzentration = 50 g/l) von Oxiden befreit. Anschließend wurden die so behandelten Kupferfolienstücke wiederum mit einem handelsüblichen wässrigen Reinigungsmittel gereinigt und mit Wasser gespült.

Die derart vorbehandelten Kupferfolienstücke wurden danach wie nachstehend beschrieben mit einer Beschichtung versehen.

### 1.1 Beispiel 1

Die vorbehandelten Kupferfolienstücke wurden bei einer Temperatur von 45°C für 30 s in eine Vortauchlösung eingebracht, die Salpetersäure und einen Komplexbildner enthielt. Danach wurden die Kupferfolienstücke direkt in eine salpetersaure Silbernitratlösung (Silbergehalt = 1,0 g/l) bei einer Temperatur von 55°C eingetaucht. Die Eintauchzeit betrug 200 s. Dabei wurden Kupferfolienstücke mit einer an der Unterseite angeordneten Silberschicht erhalten, die eine Dicke von 203 nm aufwies.

Auf die Silberschicht wurde sodann eine Silbersinterschicht aufgebracht. Hierzu wurde auf einen Bereich von 7,1 mm x 7,1 mm eine Sinterpaste (ASP 043-60, Heraeus) mittels Schablonendrucks aufgebracht (Nassschichtdicke = 50 µm). Außer dem mit Sinterpaste versehenen Bereich wies die Silberschicht einen umlaufenden, von Sinterpaste freien Randbereich von 0,25 mm Breite auf. Die so mit einer Sinterpaste auf der Silberschicht versehenen Kupferfolienstücke wurden anschließend an Luftatmosphäre für zehn Minuten bei 110°C getrocknet, vom Rahmen entfernt, von der Transferfolie gelöst und unter Trennung der Stege mittels Laser vereinzelt, wobei Substratanordnungen gemäß Beispiel 1 erhalten wurden.

### 1.2 Beispiel 2

Die Substratanordnungen gemäß Beispiel 2 wurden analog zu den Substratanordnungen gemäß Beispiel 1 hergestellt, wobei jedoch die Eintauchzeit der Kupferfolienstücke in die salpetersaure Silbernitratlösung (Silbergehalt = 1,0 g/l) bei einer Temperatur von 55°C 400 s betrug. Dabei wurden Kupferfolienstücke mit einer an der Unterseite angeordneten Silberschicht erhalten, die eine Dicke von 398 nm aufwies.

### 1.3 Beispiel 3

Die Substratanordnungen gemäß Beispiel 3 wurden analog zu den Substratanordnungen gemäß Beispiel 1 hergestellt, wobei jedoch die Eintauchzeit der Kupferfolienstücke in die salpetersaure Silbernitratlösung (Silbergehalt = 1,0 g/l) bei einer Temperatur von 55°C 600 s betrug. Dabei wurden Kupferfolienstücke mit einer an der Unterseite angeordneten Silberschicht erhalten, die eine Dicke von 606 nm aufwies.

### 1.4 Beispiel 4

Die Substratanordnungen gemäß Beispiel 4 wurden analog zu den Substratanordnungen gemäß Beispiel 1 hergestellt, wobei jedoch die Eintauchzeit der Kupferfolienstücke in die salpetersaure Silbernitratlösung (Silbergehalt = 1,0 g/l) bei einer Temperatur von 55°C 800 s betrug. Dabei wurden Kupferfolienstücke mit einer an der Unterseite angeordneten Silberschicht erhalten, die eine Dicke von 793 nm aufwies.

### 1.5 Vergleichsbeispiel 1

Die Substratanordnungen gemäß Vergleichsbeispiel 1 wurden analog zu den Substratanordnungen gemäß Beispiel 1 hergestellt, wobei jedoch die Eintauchzeit der Kupferfolienstücke in die salpetersaure Silbernitratlösung (Silbergehalt = 1,0 g/l) bei einer Temperatur von 55°C 15 s betrug. Dabei wurden Kupferfolienstücke mit einer an der Unterseite angeordneten Silberschicht erhalten, die eine Dicke von 17 nm aufwies.

### 1.6 Vergleichsbeispiel 2

Die vorbehandelten Kupferfolienstücke wurden an ihrer Unterseite elektrolytisch zunächst mit einer 5 µm dicken Nickelschicht versehen. Auf der Nickelschicht wurde sodann elektrolytisch eine 150 nm dicke Palladiumschicht abgeschieden. Anschließend wurde auf der Palladiumschicht wiederum elektrolytisch eine 90 nm dicke Goldschicht erzeugt. Dabei wurden Kupferfolienstücke erhalten, die eine an der Unterseite angeordnete Beschichtung aus Nickel, Palladium und Gold mit einer Gesamtschichtdicke von 5,24 µm aufwiesen.

Auf die Beschichtung (genauer die Goldschicht der Beschichtung) wurde sodann eine Silbersinterschicht aufgebracht. Hierzu wurde auf einen Bereich von 7,1 mm x 7,1 mm eine Sinterpaste (ASP 043-60, Heraeus) mittels Schablonendrucks aufgebracht (Nassschichtdicke = 40 µm). Außer dem mit Sinterpaste versehenen Bereich wies die Beschichtung einen umlaufenden, von Sinterpaste freien Randbereich von 0,25 mm Breite auf. Die so mit einer Sinterpaste auf der Beschichtung versehenen Kupferfolienstücke wurden anschließend an Luftatmosphäre für zehn Minuten bei 110°C getrocknet, vom Rahmen entfernt, von der Transferfolie gelöst und unter Trennung der Stege mittels Laser vereinzelt, wobei Substratanordnungen gemäß Vergleichsbeispiel 2 erhalten wurden.

### 1.7 Vergleichsbeispiel 3

Die vorbehandelten Kupferfolienstücke wurden an ihrer Unterseite elektrolytisch mit einer 1500 nm dicken Silberschicht versehen.

Auf die Silberschicht wurde sodann eine Silbersinterschicht aufgebracht. Hierzu wurde auf einen Bereich von 7,1 mm x 7,1 mm eine Sinterpaste (ASP 043-60, Heraeus) mittels Schablonendrucks aufgebracht (Nassschichtdicke = 40 µm). Außer dem mit Sinterpaste versehenen Bereich wies die Silberschicht einen umlaufenden, von Sinterpaste freien Randbereich von 0,25 mm Breite auf. Die so mit einer Sinterpaste auf der Silberschicht versehenen Kupferfolienstücke wurden anschließend an Luftatmosphäre für zehn Minuten bei 110°C getrocknet, vom Rahmen entfernt, von der Transferfolie gelöst und unter Trennung der Stege mittels Laser vereinzelt, wobei Substratanordnungen gemäß Vergleichsbeispiel 3 erhalten wurden.

### 2. Herstellung von elektronischen Baugruppen

### 2.1 Beispiel 1

Zur Herstellung einer elektronischen Baugruppe wurde zunächst eine Anordnung aus einem Grundsubstrat und einem Elektronikbauteil geschaffen. Als Grundsubstrat wurde ein kommerziell erhältliches direktmetallisiertes Kupfer-Keramik-Substrat (DCB; Condura^{®} classic, Heraeus) und als Elektronikbauteil ein Siliziumchip mit der Abmessung 8,8 mm x 8,8 mm (Dicke = 70 µm), der eine unterseitige Metallisierung (NiP/Pd) sowie eine oberseitige Metallisierung (NiP/Pd) aufwies, verwendet.

Auf die Oberseite des Kupfer-Keramik-Substrats wurde eine Sinterpaste (ASP 338-28, Heraeus) mittels Schablonendrucks aufgebracht (Nassschichtdicke = 100 µm). Das mit Sinterpaste versehene Kupfer-Keramik-Substrat wurde an Luftatmosphäre für zehn Minuten bei 100°C getrocknet und anschließend abgekühlt. Auf der vorgetrockneten Sinterpaste wurde der Siliziumchip positioniert, so dass die Unterseite des Siliziumchips mit der Oberseite des Kupfer-Keramik-Substrats in Kontakt stand.

Anschließend wurde die Substratanordnung gemäß Beispiel 1 (vgl. Punkt 1.1) auf der Oberseite des Siliziumchips positioniert, so dass die Silbersinterschicht der Substratanordnung mit der Oberseite des Siliziumchips in Kontakt stand.

Sodann wurde der erhaltene Aufbau gesintert. Das Sintern erfolgte in einer Sinterpresse (Fa. Pink, Wertheim) für eine Dauer von drei Minuten in einer Stickstoffatmosphäre bei einem Druck von 20 MPa und einer Temperatur von 250°C. Dabei wurde eine elektronische Baugruppe erhalten.

### 2.2 Beispiele 2 - 4

Mit den Substratanordnungen der Beispiele 2 - 4 (vgl. Punkte 1.2 - 1.4) wurden ebenfalls elektronische Baugruppen hergestellt. Dabei wurde analog zur Herstellung der elektronischen Baugruppe mit der Substratanordnung von Beispiel 1 verfahren.

### 2.3 Vergleichsbeispiele 1 - 3

Mit den Substratanordnungen der Vergleichsbeispiele 1 - 3 (vgl. Punkte 1.5 - 1.7) wurden ebenfalls elektronische Baugruppen hergestellt. Dabei wurde analog zur Herstellung der elektronischen Baugruppe mit der Substratanordnung von Beispiel 1 verfahren.

### 3. Auswertung

Die Substratanordnungen der Beispiele 1 - 4 und der Vergleichsbeispiele 1 - 3 wurden im Hinblick auf ihre Haftfestigkeit, den Grad an Silberrückständen und die Ausbildung einer Diffusionszone untersucht. Die Ergebnisse sind in Tabelle 1 dargestellt.

### 3.1 Bestimmung der Haftfestigkeit

Die mit den Substratanordnungen der Beispiele 1 - 4 und der Vergleichsbeispiele 1 - 3 hergestellten elektronischen Baugruppen wurden in Bezug auf die Haftfestigkeit der Metallfolien auf der Oberseite der Siliziumchips untersucht. Mittels der Materialprüfmaschine Condor Sigma (xyztec bv, Niederlande) wurde die Kraft gemessen, die aufgebracht werden musste, um die mit der Oberseite der Siliziumchips stoffschlüssig verbundenen Metallfolien von der Oberseite der Siliziumchips abzuziehen. Hierzu wurden die mit den Substratanordnungen der Beispiele 1 - 4 und der Vergleichsbeispiele 1 - 3 hergestellten elektronischen Baugruppen in einer Schraubenspannvorrichtung fixiert und in einem Abzugswinkel von 90° nach oben mit einer Geschwindigkeit von 1mm/s abgezogen. Die in Tabelle 1 angegebenen Werte geben jeweils die Maximalwerte wieder.

### 3.2 Bestimmung des Grads an Silberrückständen

Die bei der Bestimmung der Haftfestigkeit gemäß 3.1 abgezogenen Metallfolien wurden optisch in Bezug auf Silberrückstände untersucht.

### 3.3 Bestimmung der Ausbildung einer Diffusionszone

Zur Bestimmung der Ausbildung einer Diffusionszone wurde ein Schliff durch die elektronische Baugruppe senkrecht zur Metallfolie angefertigt. Die Schlifffläche wurde unter einem Rasterelektronenmikroskop in einem Linienscan abgefahren und dabei mittels REM-EDX die Elementverteilung gemessen. Es wurden die Elementsignale (in cps, counts per second) in Abhängigkeit von der Messlänge (in µm) bestimmt. Die so erhaltenen Kurven zur Elementverteilung wurden anschließend ausgewertet. Beginnend von einem ersten Abfall des Kupfersignals bis zu einem Wert von ca. 0 cps (Grundrauschen) erstreckte sich die Diffusionszone.

**Tabelle 1: Ergebnisse der Untersuchung der Substratanordnungen der Beispiele 1 - 4 und der Vergleichsbeispiele 1 - 3.**

| | Haftfestigkeit (Kraft in N) | Silberrückstände | Diffusionszone (Länge in µm) |
|---|---|---|---|
| Beispiele | | | |
| 1 | 15 | Hoch | Ca. 1,0 |
| 2 | 17 | Hoch | Ca. 1,0 |
| 3 | 16 | Hoch | Ca. 1,0 |
| 4 | 17 | Hoch | Ca. 1,0 |
| Vergleichsbeispiele | | | |
| 1 | 10 | Gering | Ca. 0,3 |
| 2 | 12 | Mittel | Ca. 0,3 |
| 3 | 13 | Mittel | Ca. 1,0, aber keine Diffusion durch die gesamte Silberschicht hindurch |

### 4. Auswertung

Die Ergebnisse zeigen, dass die erfindungsgemäßen Substratanordnungen gemäß den Beispielen 1 - 4 den Substratanordnungen gemäß den Vergleichsbeispielen 1 - 3 im Hinblick auf ihre Haftfestigkeit, den Grad an Silberrückständen und der Ausbildung einer Diffusionszone überlegen sind. So weisen die mit den Substratanordnungen der Beispiele 1 - 4 erzeugten Verbindungen eine gegenüber den mit den Substratanordnungen der Vergleichsbeispiele 1 - 3 erzeugten Verbindungen eine deutlich erhöhte Haftfestigkeit auf. Die bei der Messung der Haftfestigkeit abgezogenen Metallfolien weisen einen hohen Grad an Silberrückständen auf. Daraus lässt sich schließen, dass die Haftfestigkeit der Verbindung zwischen der Metallfolie und der Verbindungszone so stark ausgeprägt ist, dass ein Abreißen der Verbindung nicht an der Grenzfläche zwischen Metallfolie und Verbindungszone erfolgt, sondern in der Verbindungszone selbst. Damit einhergehend weist ein Vergleich der Diffusionszonenlängen darauf hin, dass die erfindungsgemäßen Substratanordnungen gemäß den Beispielen 1 - 4 eine ausgeprägte Diffusion des Metalls der Metallfolie in Richtung der Oberseite des Elektronikbauteils ermöglichen, die eine Zunahme der Haftfestigkeit bewirkt. Eine ausgeprägte Diffusionszone ist auch mit der Substratanordnung gemäß Vergleichsbeispiel 3 erreichbar. Allerdings scheint die Silberschicht der Substratanordnung als Diffusionssperre zu wirken, die keine Diffusion bis zur Oberseite des Elektronikbauteils zulässt und somit nichts zur Steigerung der Haftfestigkeit beitragen kann.

### Bezugszeichenliste:

- 10: Substratanordnung
- 26: Metallfolie
- 23: Oberseite (Metallfolie)
- 24: Unterseite (Metallfolie)
- 30: Silbersinterschicht
- 40: Elektronikbauteil
- 43: Oberseite (Elektronikbauteil)
- 44: Unterseite (Elektronikbauteil)
- 50: Grundsubstrat
- 53: Oberseite (Grundsubstrat)
- 55, 55': Metallschicht
- 56: Schicht aus isolierendem Material
- 100: Elektronische Baugruppe

## Patentansprüche

1. Substratanordnung aufweisend
(a) eine Metallfolie, die eine Oberseite und eine Unterseite umfasst,
(b) eine Silberschicht, die auf der Unterseite der Metallfolie angeordnet ist, und
(c) eine Silbersinterschicht, die auf der Silberschicht angeordnet ist,
**dadurch gekennzeichnet, dass** die Silberschicht eine Dicke d(Ag) im Bereich von 20 - 1500 nm aufweist.

2. Substratanordnung nach Anspruch 1, **dadurch gekennzeichnet, dass** die Metallfolie Kupfer umfasst.

3. Substratanordnung nach Anspruch 1 oder 2, **dadurch gekennzeichnet, dass** die Metallfolie eine Dicke d(Me) im Bereich von 20 - 400 µm aufweist.

4. Substratanordnung nach einem der vorangegangenen Ansprüche, **dadurch gekennzeichnet, dass** die Silberschicht auf der Unterseite der Metallfolie außenstromlos abgeschieden ist.

5. Substratanordnung nach einem der vorangegangenen Ansprüche, **dadurch gekennzeichnet, dass** die Silbersinterschicht ein Sintermaterial umfasst.

6. Substratanordnung nach einem der vorangegangenen Ansprüche, **dadurch gekennzeichnet, dass** die Silbersinterschicht eine vorgetrocknete Sinterpaste umfasst.

7. Substratanordnung nach einem der vorangegangenen Ansprüche, **dadurch gekennzeichnet, dass** das Verhältnis R = d(Ag) / d(Me) weniger als 0,05 beträgt.

8. Substratanordnung nach einem der vorangegangenen Ansprüche, **dadurch gekennzeichnet, dass** das Verhältnis R = d(Ag) / d(Me) weniger als 0,005 beträgt.

9. Substratanordnung nach einem der vorangegangenen Ansprüche, **dadurch gekennzeichnet, dass** die Substratanordnung zur Verbindung mit wenigstens einem Elektronikbauteil ausgestaltet ist.

10. Verfahren zur Herstellung einer elektronischen Baugruppe umfassend die Schritte
(A) Bereitstellung eines Grundsubstrats, das eine Oberseite aufweist, wobei das Grundsubstrat eine Metallschicht umfasst,
(B) Bereitstellung eines Elektronikbauteils, das eine Oberseite und eine Unterseite aufweist, und
(C) Bereitstellung einer Substratanordnung gemäß einem der vorangegangenen Ansprüche,
(D) Kontaktierung der Oberseite des Grundsubstrats mit der Unterseite des Elektronikbauteils unter Ausbildung einer stoffschlüssigen Verbindung und
(E) Kontaktierung der Oberseite des Elektronikbauteils mit der Kontaktierungsschicht der Substratanordnung unter Ausbildung einer stoffschlüssigen Verbindung.

11. Elektronische Baugruppe herstellbar durch ein Verfahren gemäß Anspruch 10.
